# FASCICULE DE BREVET EUROPEEN

(11) **EP 2 230 208 B1**
(45) Date de publication et mention de la délivrance du brevet: **08.01.2014**
(21) Numéro de dépôt: 10154909.5
(22) Date de dépôt: 26.02.2010
(51) Int. Cl.: B81C 1/00, B81C 99/00, C25D 1/10, B29C 33/38

(54) **Moule pour galvanoplastie et son procédé de fabrication**
Form für Galvanoplastik und ihr Herstellungsverfahren
Electroplating mould and method for manufacturing the same

(30) Priorité: 13.03.2009 EP 09155125
(43) Date de publication de la demande: 22.09.2010
(73) Titulaire: Nivarox-FAR S.A., 2400 Le Locle (CH)
(72) Inventeur: Cusin, Pierre, 1423, Villars-Burquin (CH); Golfier, Clare, 2520, La Neuveville (CH); Thiébaud, Jean-Philippe, 1588, Cudrefin (CH)
(74) Mandataire: Couillard, Yann Luc Raymond

(56) Documents cités:
- EP-A- 0 547 371
- EP-A- 1 462 859
- EP-A- 1 681 375
- EP-A- 2 060 534
- DE-C1- 4 001 399

## Description

### Domaine de l'invention

L'invention se rapporte à un moule destiné à fabriquer une pièce de micromécanique par galvanoplastie ainsi que son procédé de fabrication.

### Arrière plan de l'invention

La galvanoplastie est utilisée et connue depuis longtemps. Les procédés du type LIGA (abréviation très connue provenant de l'allemand « röntgenLithographie, Galvanoformung & Abforrnung ») sont plus récents. Ils consistent à former un moule par photolithographie d'une résine photosensible puis d'y faire croître par galvanoplastie un dépôt métallique comme du nickel. La précision de tels procédés LIGA est bien meilleure que celle d'un moule classique obtenue, par exemple, par usinage. De telles précisions autorisent ainsi la fabrication de pièces de micromécanique notamment pour des mouvements horlogers qui étaient avant inenvisageables (voir par exemple les demandes de brevet EP 1681375 et EP 0547371).

Cependant, de tels procédés ne sont pas adaptés pour les pièces de micromécanique à grand élancement comme une roue d'échappement coaxiale en nickel - phosphore à, par exemple, 12% de phosphore. En effet, les dépôts électrolytiques de ce type de pièce délaminent en cours de dépôt en raison des contraintes internes du nickel - phosphore déposé ce qui a pour conséquence un décollement au niveau de son interface avec le substrat.

### Résumé de l'invention

Le but de la présente invention est de pallier tout ou partie les inconvénients cités précédemment en proposant un moule alternatif offrant au moins les mêmes précisions de fabrication et autorisant la fabrication de pièces à plusieurs niveaux et/ou à grand élancement.

A cet effet, l'invention se rapporte à un procédé de fabrication d'un moule comportant les étapes suivantes :
a) se munir d'un substrat comportant une couche supérieure et une couche inférieure en silicium cristallin dopé électriquement conducteur et solidarisées entre elles par une couche intermédiaire électriquement isolante ;
b) graver au moins un motif dans la couche supérieure jusqu'à la couche intermédiaire afin de former au moins une cavité dudit moule ;
c) recouvrir la partie supérieure dudit substrat d'un revêtement électriquement isolant ;
d) graver de manière directionnelle ledit revêtement et ladite couche intermédiaire afin de limiter leur présence uniquement au niveau de chaque paroi verticale formée dans ladite couche supérieure.

Conformément à d'autres caractéristiques avantageuses de l'invention :
- un deuxième motif est gravé lors de l'étape b) afin de former au moins un évidement communiquant avec ladite au moins une cavité offrant à ladite couche supérieure un deuxième niveau ;
- une pièce est montée après l'étape d) afin de former au moins un évidement communiquant avec ladite au moins une cavité offrant audit moule un deuxième niveau ;
- le procédé comporte l'étape finale e) : former une tige par photolithographie dans ladite au moins une cavité afin de former un trou dans la future pièce réalisée dans ledit moule ;
- l'étape b) comporte les phases f) : structurer au moins un masque de protection sur la couche conductrice supérieure, g) : réaliser une attaque anisotrope de ladite couche supérieure selon les parties non recouvertes par ledit au moins un masque de protection et h) : retirer le masque de protection ;
- le procédé comporte, à la suite des étapes précédentes, les étapes a') : déposer un matériau électriquement conducteur dans le fond de ladite au moins une cavité, b'): graver un motif dans la couche inférieure jusqu'au dépôt dudit matériau conducteur afin de former au moins une cavité dudit moule et c'): recouvrir l'ensemble d'un deuxième revêtement électriquement isolant ;
- le procédé comporte, à la suite de l'étape c'), l'étape d'): graver de manière directionnelle ledit deuxième revêtement afin de limiter sa présence uniquement au niveau de chaque paroi verticale formée dans ladite couche inférieure ;
- un deuxième motif est gravé lors de l'étape b') afin de former au moins un évidement communiquant avec ladite au moins une cavité offrant à ladite couche inférieure un deuxième niveau ;
- une pièce est montée après l'étape d') afin de former au moins un évidement communiquant avec ladite au moins une cavité offrant audit moule un deuxième niveau ;
- le procédé comporte l'étape finale e'): former une tige par photolithographie dans ladite au moins une cavité de la couche inférieure afin de former un trou dans la future pièce réalisée dans ledit moule ;
- l'étape b') comporte les phases f') : structurer au moins un masque de protection sur la couche conductrice supérieure, g'): réaliser une attaque anisotrope de ladite couche supérieure selon les parties non recouvertes par ledit au moins un masque de protection et h'): retirer le masque de protection ;
- plusieurs moules sont fabriqués sur le même substrat ;
- l'étape c) est obtenue par oxydation de la partie supérieure dudit substrat ;
- le revêtement électriquement isolant est formé par du dioxyde de silicium.

L'invention se rapporte également à un procédé de fabrication par galvanoplastie d'une pièce de micromécanique, caractérisé **en ce qu**'il comprend les étapes suivantes :
i) fabriquer un moule selon le procédé conforme à l'une des variantes précédentes;
j) réaliser une électrodéposition en connectant l'électrode à la couche conductrice inférieure du substrat afin de former ladite pièce dans ledit moule ;
k) libérer la pièce dudit moule.

Enfin, l'invention se rapporte à un moule destiné à fabriquer une pièce de micromécanique par galvanoplastie, caractérisé **en ce qu**'il comporte un substrat comportant une couche supérieure et une couche inférieure en silicium cristallin dopé électriquement conductrices et solidarisées entre elles par une couche intermédiaire électriquement isolante, la couche supérieure comportant au moins une cavité découvrant une partie de la couche inférieure dudit substrat et comportant des parois électriquement isolantes permettant de faire croître un dépôt électrolytique dans ladite au moins une cavité.

Conformément à d'autres caractéristiques avantageuses de l'invention :
- la couche supérieure comporte en outre au moins un évidement situé communiquant avec ladite au moins une cavité et comportant des parois électriquement isolantes permettant de continuer le dépôt électrolytique dans ledit au moins un évidement après avoir rempli ladite au moins une cavité ;
- la couche inférieure comporte au moins une cavité découvrant une partie de couche électriquement conductrice dudit substrat et comportant des parois électriquement isolantes permettant de faire croître un dépôt électrolytique dans ladite au moins une cavité de la couche inférieure ;
- la couche inférieure comporte en outre au moins un évidement situé communiquant avec ladite au moins une cavité de la couche inférieure et comportant des parois électriquement isolantes permettant de continuer le dépôt électrolytique dans ledit au moins un évidement après avoir rempli ladite au moins une cavité de la couche inférieure.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 7 sont des représentations des étapes successives d'un procédé de fabrication d'une pièce de micromécanique selon un premier mode de réalisation de l'invention ;
- les figures 8 à 12 sont des représentations des étapes successives d'un procédé de fabrication d'une pièce de micromécanique selon un deuxième mode de réalisation de l'invention ;
- la figure 13 est un schéma fonctionnel d'un procédé de fabrication d'une pièce de micromécanique selon l'invention ;
- les figures 14 à 19 sont des représentations des étapes successives d'un procédé de fabrication d'une pièce de micromécanique selon une variante de l'invention.

### Description détaillée des modes de réalisation préférés

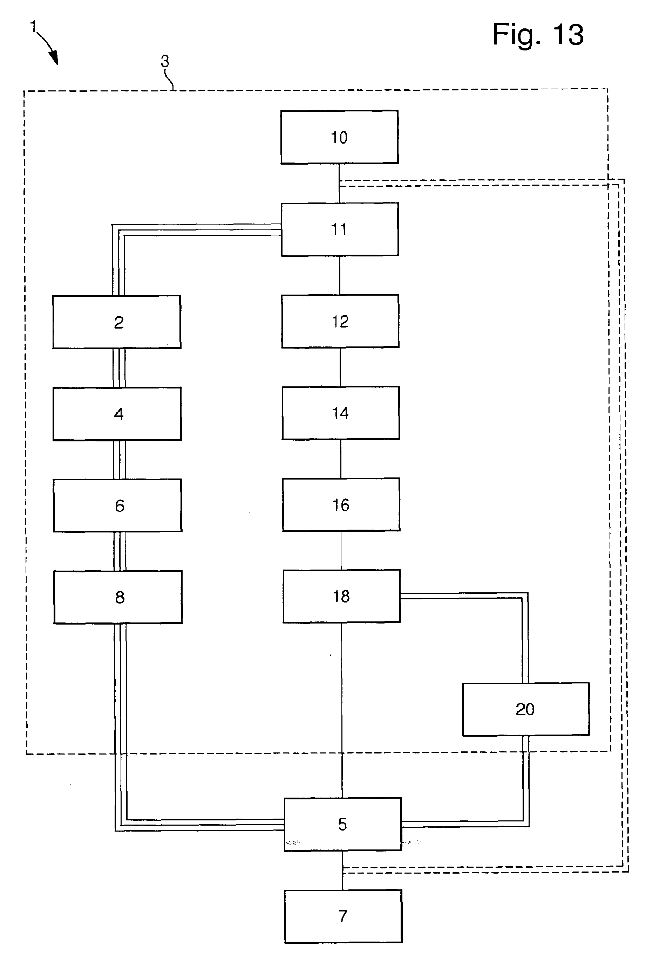

Comme visible à la figure 13, l'invention se rapporte à un procédé de fabrication 1 d'une pièce de micromécanique 41, 41', 41" par galvanoplastie. Le procédé 1 comporte, préférentiellement, un procédé de fabrication 3 d'un moule 39, 39', 39" suivi des étapes de galvanoplastie 5 et de libération 7 de la pièce 41, 41', 41" dudit moule.

Le procédé de fabrication 3 du moule comporte des étapes successives destinées à fabriquer un moule 39, 39', 39" comportant, préférentiellement, des matériaux à base de silicium.

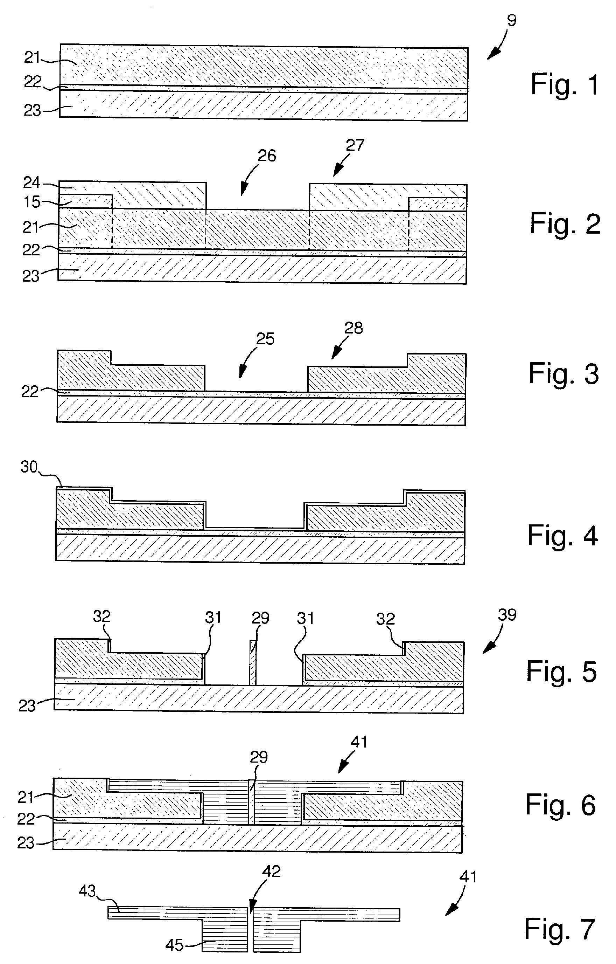

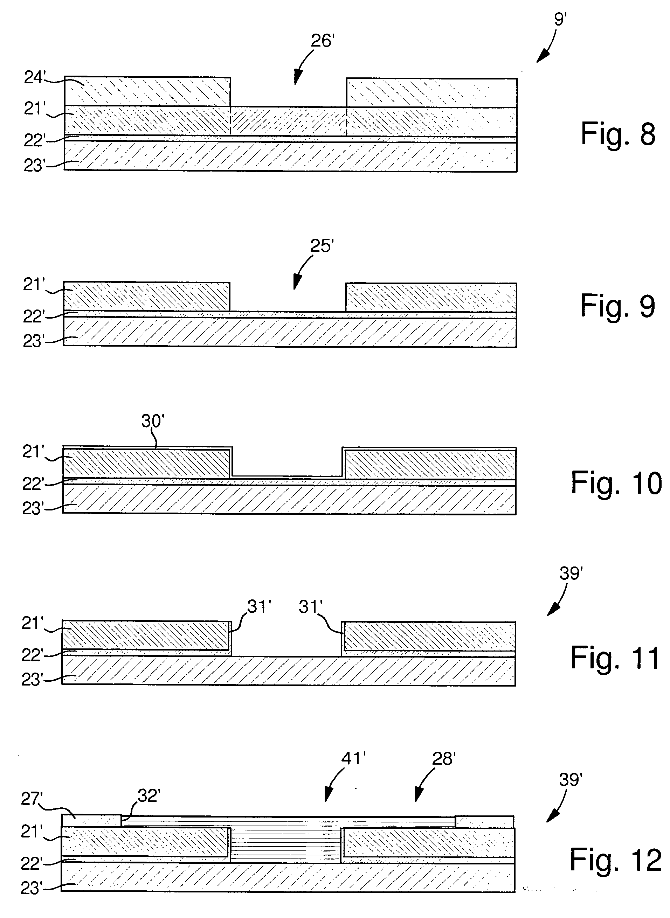

Une première étape 10 du procédé 3 consiste à se munir d'un substrat 9, 9' comportant une couche supérieure 21, 21' et une couche inférieure 23, 23', en matériaux micro-usinables électriquement conducteurs, solidarisées entre elles par une couche intermédiaire 22, 22' électriquement isolante comme illustré aux figures 1 et 8.

Préférentiellement, le substrat 9, 9' est un S.O.I. (abréviation très connue provenant des termes anglais « Silicon On Isulator »). De plus, les couches supérieure 21, 21' et inférieure 23, 23' sont en silicium cristallin suffisamment dopé afin d'être électriquement conductrices et la couche intermédiaire en dioxyde de silicium.

Selon l'invention, le procédé 3 comporte deux modes de réalisation distincts à partir de l'étape 11 respectivement représenté par un trait triple et un trait simple à la figure 13.

Selon un premier mode de réalisation, lors de la deuxième étape 11, un masque 15 puis un masque 24 de protection sont structurés sur la couche conductrice supérieure 21 comme illustré à la figure 2. Comme visible également à la figure 2, le masque 15 comporte au moins un motif 27 qui ne recouvre pas la couche supérieure 21. De plus, préférentiellement, le masque 24, qui recouvre totalement le masque 15, comporte au moins un motif 26 qui ne recouvre pas la couche supérieure 21.

A titre d'exemple, le masque 15 peut être réalisé par dépôt d'une couche d'oxyde de silicium afin de former ledit masque jusqu'à une hauteur prédéterminée. Ensuite, le masque 24 peut, par exemple, être obtenu par photolithographie à l'aide d'une résine photosensible en recouvrement du masque 15.

Selon le premier mode de réalisation visible en trait triple à la figure 13, dans une troisième étape 2, la couche supérieure 21 est gravée jusqu'à découvrir la couche intermédiaire 22. Selon l'invention, l'étape 2 de gravage comporte, de manière préférée, une attaque sèche anisotrope du type gravage ionique réactif profond (DRIE provenant des termes anglais « Deep Reactive Ion Etching »).

Dans un premier temps de l'étape 2, on effectue une attaque anisotrope dans la couche supérieure 21 selon le motif 26 du masque 24. Cette attaque permet de commencer la gravure d'au moins une cavité 25 dans la couche supérieure 21 sur une partie de son épaisseur. Dans un deuxième temps, on retire le masque 24 puis on effectue une deuxième attaque anisotrope selon le motif 27 du masque 15 encore présent sur la couche supérieure 21. La deuxième attaque permet de continuer la gravure de ladite au moins une cavité 25 mais également de commencer la gravure d'au moins un évidement 28 qui communique avec ladite au moins une cavité 25 tout en étant de plus grande section.

Dans une quatrième étape 4, le masque 15 est retiré. Ainsi, comme visible à la figure 3, à la fin de la quatrième étape 4, la couche supérieure 21 est gravée sur toute son épaisseur de ladite au moins une cavité 25 et sur une partie supérieure de son épaisseur dudit au moins un évidement 28.

Dans une cinquième étape 6, un revêtement 30 électriquement isolant est déposé en recouvrant l'ensemble supérieur du substrat 9 comme illustré à la figure 4. Préférentiellement, le revêtement 30 est obtenu par oxydation du dessus de la couche supérieure 21 gravée et de la couche intermédiaire 22.

Selon une sixième étape 8, un gravage directionnel du revêtement 30 et de la couche intermédiaire 22 est réalisé. L'étape 8 est destinée à limiter la présence de couches isolantes uniquement au niveau de chaque paroi verticale formée dans la couche supérieure 21, c'est-à-dire les parois 31 et 32 respectivement de ladite au moins une cavité 25 et dudit au moins un évidement 28. Selon l'invention, lors d'un gravage directionnel ou anisotrope, la composante verticale du phénomène de gravure est favorisée par rapport à la composition horizontale, en modulant, par exemple, la pression dans la chambre (travail à pression très basse), dans un réacteur RIE. Un tel gravage peut, à titre d'exemple, être du type « ion milling » ou « sputter etching ».

En réalisant cette étape 8 et comme illustré à la figure 5, on comprend que le fond de la cavité 25 découvre la couche inférieure 23 électriquement conductrice et que le fond de l'évidement 28 découvre la couche supérieure 21 également conductrice.

Afin d'améliorer l'accrochage de la future galvanoplastie, une couche d'accrochage sur le fond de chaque cavité 25 et/ou sur le fond de chaque évidement 28 peut être prévue. La couche d'accrochage pourrait alors consister en un métal comme de l'alliage CrAu.

Préférentiellement, lors de la sixième étape 8, comme illustré à la figure 5, une tige 29 est montée afin de former directement le trou 42 d'axe de la pièce 41 de micromécanique lors de l'étape 5 de galvanoplastie. Cela présente l'avantage non seulement de ne pas à avoir à usiner la pièce 41 une fois la galvanoplastie terminée mais également de pouvoir réaliser n'importe quelle forme de section intérieure, de manière uniforme ou non, sur toute la hauteur du trou 42. Préférentiellement, la tige 29 est obtenue, par exemple, à l'aide d'un procédé de photolithographie d'une résine photosensible.

Dans le premier mode de réalisation, à la suite de l'étape 8, le procédé de fabrication 3 du moule 39 est terminé et le procédé de fabrication 1 de la pièce de micromécanique se poursuit par les étapes de galvanoplastie 5 et de libération 7 de la pièce 41 du moule 39.

L'étape 5 de galvanoplastie est réalisée en connectant l'électrode de dépôt à la couche inférieure 23 du moule 39 afin de faire croître dans un premier temps un dépôt électrolytique dans la cavité 25 dudit moule puis, seulement dans un deuxième temps, dans l'évidement 28 comme illustré à la figure 6.

En effet, avantageusement selon l'invention, lorsque le dépôt électrolytique affleure de la partie supérieure de la cavité 25, il connecte électriquement la couche supérieure 21 par, éventuellement, sa couche d'accrochage, ce qui permet la continuation de la croissance du dépôt sur l'ensemble de l'évidement 28. Avantageusement, l'invention permet la réalisation de pièces 41 à grand élancement, c'est-à-dire quand la section de la cavité 25 est beaucoup plus petite que celle de l'évidement 28, en évitant les problèmes de décollement même avec un matériau en nickel - phosphore à, par exemple, 12% de phosphore.

En effet, grâce à l'utilisation du silicium comme couches conductrices 21, 23, et éventuellement leur couche d'accrochage, les phénomènes de délamination aux interfaces sont diminués ce qui évite les décollements induits par les contraintes internes du matériau électrodéposé.

Selon le premier mode de réalisation, le procédé de fabrication 1 se termine par l'étape 7, dans laquelle la pièce 41 formée dans la cavité 25 puis dans l'évidement 28 est libérée du moule 39. L'étape 7 de libération peut, par exemple, être effectuée par gravure des couches 23 et 21. Selon ce premier mode de réalisation, on comprend comme illustré à la figure 7 que la pièce de micromécanique 41 obtenue comporte deux niveaux 43, 45 de forme différente chacun selon une épaisseur parfaitement indépendante et comportant un unique trou d'axe 42.

Une telle pièce de micromécanique 41 pourrait, par exemple, être une roue d'échappement coaxiale ou un ensemble roue d'échappement 43 - pignon 45 comportant une précision géométrique de l'ordre du micromètre mais également un référencement idéal c'est-à-dire un positionnement parfait entre lesdits niveaux.

Selon un deuxième mode de réalisation de l'invention, le procédé 3 comporte une deuxième étape 11, consistant à structurer au moins un masque 24' de protection sur la couche conductrice supérieure 21' comme illustré à la figure 8. Comme visible également à la figure 8, le masque 24' comporte au moins un motif 26' qui ne recouvre pas la couche supérieure 21'. Un tel masque 24' peut, par exemple, être obtenu par photolithographie à l'aide d'une résine photosensible.

Dans une troisième étape 12, la couche supérieure 21' est gravée jusqu'à découvrir la couche intermédiaire 22'. Selon l'invention, l'étape 12 de gravage comporte, de manière préférée, une attaque sèche anisotrope du type gravage ionique réactif profond (DRIE). L'attaque anisotrope est effectuée dans la couche supérieure 21' selon le motif 26' du masque 24'.

Dans une quatrième étape 14, le masque 24' est retiré. Ainsi, comme visible à la figure 9, à la fin de la quatrième étape 14, la couche supérieure 21' est gravée sur toute son épaisseur d'au moins une cavité 25'.

Dans une cinquième étape 16, un revêtement 30' électriquement isolant est déposé en recouvrant l'ensemble supérieur du substrat 9' comme illustré à la figure 10. Préférentiellement, le revêtement 30' est obtenu par oxydation du dessus de la couche supérieure 21' gravée et de la couche intermédiaire 22'.

Selon une sixième étape 18, un gravage directionnel du revêtement 30' et de la couche intermédiaire 22' est réalisé. L'étape 18 est destinée à limiter la présence de couches isolantes uniquement au niveau de chaque paroi verticale formée dans la couche supérieure 21', c'est-à-dire les parois 31' de ladite au moins une cavité 25'. En réalisant cette étape 18 et comme illustré à la figure 11, on comprend que le fond de la cavité 25' découvre la couche inférieure 23' électriquement conductrice et le dessus de la couche supérieure 21' également conductrice.

Comme dans le premier mode de réalisation, afin d'améliorer l'accrochage de la future galvanoplastie, une couche d'accrochage sur le fond de chaque cavité 25' et/ou sur le dessus de la couche supérieure 21' peut être prévue. La couche d'accrochage pourrait alors consister en un métal comme de l'alliage CrAu.

Lors de la sixième étape 18, comme expliqué pour le premier mode de réalisation des figures 1 à 7, une tige peut être montée afin de former directement le trou d'axe de la pièce de micromécanique lors de l'étape 5 de galvanoplastie avec les mêmes avantages que cités précédemment.

Dans le deuxième mode de réalisation, à la suite de l'étape 18, le procédé de fabrication 3 du moule 39' est terminé et le procédé de fabrication 1 de la pièce de micromécanique se poursuit par les étapes de galvanoplastie 5 et de libération 7 de la pièce du moule 39'.

L'étape 5 de galvanoplastie est réalisée en connectant l'électrode de dépôt à la couche inférieure 23' du moule 39' afin de faire croître un dépôt électrolytique dans la cavité 25' du moule 39'.

Selon le deuxième mode de réalisation, le procédé de fabrication 1 se termine par l'étape 7 similaire à celle expliquée dans le premier mode de réalisation, dans laquelle la pièce formée dans la cavité 25' est libérée du moule 39'. Selon ce deuxième mode de réalisation, on comprend que la pièce de micromécanique obtenue comporte un seul niveau de forme identique selon toute son épaisseur et pouvant comporter un trou d'axe.

Une telle pièce de micromécanique pourrait, par exemple, être une roue d'échappement ou une ancre d'échappement ou même un pignon comportant une précision géométrique de l'ordre du micromètre.

Selon une alternative à ce deuxième mode de réalisation illustré par un trait double à la figure 13, à la suite de l'étape 18, le procédé de fabrication 3 du moule 39' comporte une étape supplémentaire 20 destinée à former au moins un deuxième niveau au moule 39' comme illustré à la figure 12. Ainsi, le deuxième niveau est réalisé en montant une pièce 27', comportant des parois 32' électriquement isolantes, sur la couche supérieure 21' qui n'a pas été retirée lors de l'étape 12.

Préférentiellement, la pièce 27' ajoutée forme au moins un évidement 28' de section plus grande que les parties retirées 25', par exemple, à l'aide d'un procédé de photolithographie d'une résine photosensible. Cependant, la pièce 27' pourrait également comporter un matériau à base de silicium isolant préalablement gravé puis être solidarisée sur la couche conductrice 21'.

Par conséquent, selon l'alternative du deuxième mode de réalisation, à la suite de l'étape 20, le procédé de fabrication 3 du moule 39' est terminé et le procédé de fabrication 1 de la pièce de micromécanique se poursuit par les étapes de galvanoplastie 5 et de libération 7 de la pièce 41' du moule 39'.

L'étape 5 de galvanoplastie est réalisée en connectant l'électrode de dépôt à la couche inférieure 23' du moule 39' afin de faire croître dans un premier temps un dépôt électrolytique dans la cavité 25' dudit moule puis, seulement dans un deuxième temps, dans l'évidement 28' comme illustré à la figure 12.

En effet, avantageusement selon l'invention, lorsque le dépôt électrolytique affleure de la partie supérieure de la cavité 25', il connecte électriquement la couche supérieure 21' par, éventuellement, sa couche d'accrochage, ce qui permet la continuation de la croissance du dépôt sur l'ensemble de l'évidement 28'. Avantageusement, l'invention permet la réalisation de pièces 41' à grand élancement, c'est-à-dire quand la section de la cavité 25' est beaucoup plus petite que celle de l'évidement 28', en évitant les problèmes de décollement même avec un matériau en nickel - phosphore à, par exemple, 12% de phosphore.

En effet, grâce à l'utilisation du silicium comme couches conductrices 21', 23', et éventuellement leur couche d'accrochage les phénomènes de délamination aux interfaces sont diminués ce qui évite les décollements induits par les contraintes internes du matériau électrodéposé.

Selon l'alternative du deuxième mode de réalisation, le procédé de fabrication 1 se termine par l'étape 7 similaire à celle expliquée dans le premier mode de réalisation, dans laquelle la pièce 41' formée dans le moule 39' est libérée. On comprend comme illustré à la figure 12 que la pièce de micromécanique 41' obtenue comporte deux niveaux de forme différente chacun selon une épaisseur parfaitement indépendante et pouvant comporter un unique trou d'axe. Une telle pièce de micromécanique 41' peut par conséquent avoir la même forme que celle 41 obtenue grâce au premier mode de réalisation et ainsi comporter une précision géométrique de l'ordre du micromètre mais également un référencement idéal c'est-à-dire un positionnement parfait entre lesdits niveaux.

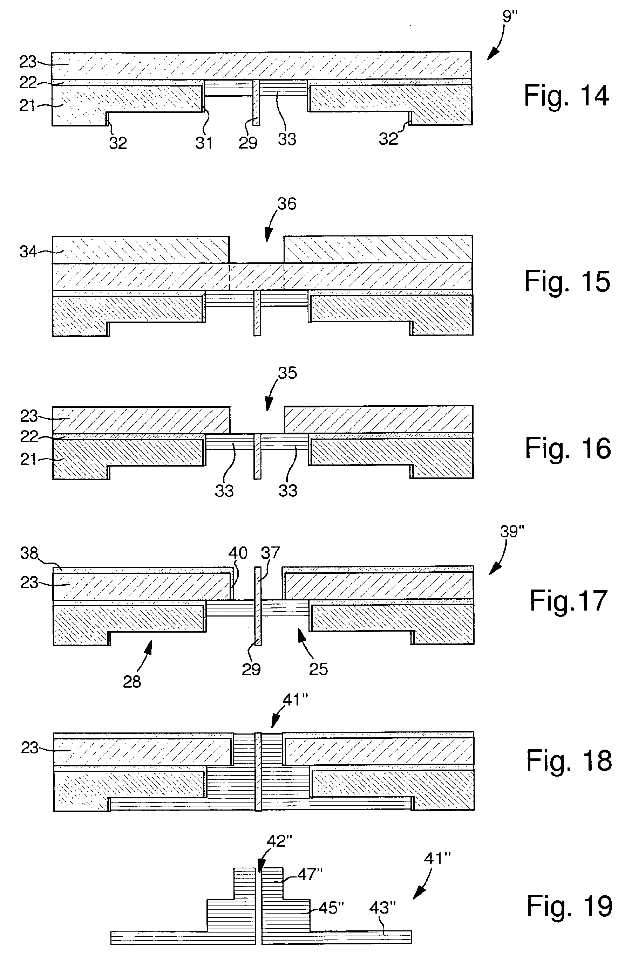

Selon une variante (illustrée en traits doubles discontinus à la figure 13) aux deux modes de réalisation du procédé 1 visible aux figures 14 à 19, il est possible d'appliquer le procédé 3 également à la couche inférieure 23, 23' afin de rajouter un ou deux autres niveaux au moule 39, 39'. Afin de ne pas surcharger les figures, un seul exemple est détaillé ci-dessus mais on comprend que la couche inférieure 23, 23' peut également être transformée selon le premier mode de réalisation ou le deuxième mode de réalisation avec son alternative ou non expliqués ci-dessus.

La variante reste identique au procédé 1 décrit ci-dessus jusqu'à l'étape 8, 18 ou 20 suivant le mode de réalisation utilisé. Dans l'exemple illustré aux figures 14 à 19, on prendra comme point de départ du procédé 1, l'exemple du premier mode de réalisation comme illustré à la figure 13 en trait triple.

Préférentiellement selon cette variante, la couche inférieure 23 est destinée à être gravée afin de former au moins une deuxième cavité 35 dans le moule 39". Comme visible, de manière préférée entre la figure 5 et la figure 14, un dépôt 33 a été réalisé dans une partie de la première cavité 25 afin de fournir une couche de départ de galvanoplastie. Préférentiellement, ce dépôt 33 est effectué en commençant l'étape 5 jusqu'à une épaisseur prédéterminée. Cependant, ce dépôt peut être effectué selon un autre procédé.

Comme illustré par des traits double discontinus à la figure 13 et les figures 14 à 19, la variante du procédé 1 applique à la couche inférieure 23, les étapes 11, 12, 14, 16 et 18 du deuxième mode de réalisation du procédé 3.

Ainsi selon la variante, le procédé 3 comporte une nouvelle étape 11, consistant à structurer au moins un masque 34 sur la couche conductrice inférieure 23 comme illustré à la figure 15. Comme visible également à la figure 15, le masque 34 comporte au moins un motif 36 qui ne recouvre pas la couche inférieure 23. Un tel masque 34 peut, par exemple, être obtenu par photolithographie à l'aide d'une résine photosensible.

Ensuite, à la nouvelle étape 12, la couche 23 est gravée selon le motif 36 jusqu'à découvrir le dépôt 33 électriquement conducteur. Puis le masque de protection 34 est retiré lors d'une nouvelle étape 14. Ainsi, comme visible à la figure 16, à la fin de l'étape 14, la couche inférieure 23 est gravée sur toute son épaisseur d'au moins une cavité 35.

Dans une nouvelle étape 16, un revêtement 38 électriquement isolant est déposé en recouvrant l'ensemble inférieur du substrat 9" comme illustré à la figure 17. Préférentiellement, le revêtement 38 est obtenu par dépôt d'un oxyde de silicium sur le dessus de la couche inférieure 23, par exemple, à l'aide d'un dépôt physique en phase vapeur.

Préférentiellement une nouvelle étape 18 n'est pas nécessaire si un seul niveau est ajouté au moule 39". Sinon, un gravage directionnel du revêtement 38 est réalisé. La nouvelle étape 18 serait destinée à limiter la présence de couche isolante uniquement au niveau de chaque paroi verticale 39 formée dans la couche inférieure 23, c'est-à-dire les parois de ladite au moins une cavité 35. Dans notre exemple des figures 14 à 19, une nouvelle étape 18 n'est effectuée que pour enlever la couche d'oxyde présente dans le fond de ladite au moins une cavité 35.

Lors de la nouvelle étape 18, comme expliqué précédemment, une tige 37 peut être montée afin de former directement le trou 42" d'axe de la pièce de micromécanique 41" lors de l'étape 5 de galvanoplastie avec les mêmes avantages que cités précédemment.

Dans la variante du procédé 1, à la suite de l'étape 18, le procédé de fabrication 3 du moule 39" est terminé et le procédé de fabrication 1 de la pièce de micromécanique se poursuit par les étapes de galvanoplastie 5 et de libération 7 de la pièce 41" du moule 39". Préférentiellement, si les tiges 29 et 37 sont formées respectivement dans les cavités 25 et 35, elles sont alignées. Préférentiellement, la tige 37 est obtenue, par exemple, à l'aide d'un procédé de photolithographie d'une résine photosensible.

A la suite des nouvelles étapes 8, 18 ou 20, l'étape 5 de galvanoplastie est réalisée en connectant l'électrode de dépôt à la couche inférieure 23 afin de faire croître un dépôt électrolytique dans la cavité 35 mais également continuer la croissance du dépôt dans la cavité 25, puis, seulement dans un deuxième temps, dans l'évidement 28 comme illustré à la figure 18. Le procédé de fabrication 1 se termine par l'étape 7, dans laquelle la pièce 41" est libérée du moule 39" comme expliqué ci-dessus.

Selon cette variante, on comprend comme illustré à la figure 19 que la pièce de micromécanique 41 " obtenue comporte au moins trois niveaux 43", 45" et 47" de forme différente chacun selon une épaisseur parfaitement indépendante avec un trou d'axe unique 42".

Une telle pièce de micromécanique pourrait, par exemple, être une roue d'échappement coaxiale 43", 45" avec son pignon 47" ou un mobile à trois niveaux de dentures 43", 45", 47" comportant une précision géométrique de l'ordre du micromètre mais également un référencement idéal c'est-à-dire un positionnement parfait entre lesdits niveaux.

Bien entendu, la présente invention ne se limite pas à l'exemple illustré mais est susceptible de diverses variantes et modifications qui apparaîtront à l'homme de l'art. Ainsi, plusieurs moules 39, 39', 39" sont fabriqués sur le même substrat 9, 9', 9" afin de réaliser une production en série de pièces de micromécanique 41, 41', 41" qui ne sont pas forcément identiques entre elles. De même, on peut également envisager changer des matériaux à base de silicium par de l'alumine cristallisée ou de la silice cristallisée ou carbure de silicium.

## Revendications

1. Procédé de fabrication (3) d'un moule (39, 39', 39") comportant les étapes suivantes :
a) se munir (10) d'un substrat (9, 9') comportant une couche supérieure (21, 21') et une couche inférieure (23, 23') en silicium cristallin dopé électriquement conducteur et solidarisées entre elles par une couche intermédiaire (22, 22') électriquement isolante ;
b) graver (11, 12, 14, 2, 4) au moins un motif (26, 26', 27) dans la couche supérieure (21, 21') jusqu'à la couche intermédiaire (22, 22') afin de former au moins une cavité (25, 25') dudit moule ;
c) recouvrir (6, 16) la partie supérieure dudit substrat d'un revêtement (30, 30') électriquement isolant ;
d) graver (8, 18) de manière directionnelle ledit revêtement et ladite couche intermédiaire afin de limiter leur présence uniquement au niveau de chaque paroi verticale (31, 31', 33) formée dans ladite couche supérieure.

2. Procédé (3) selon la revendication 1, **caractérisé en ce qu'**un deuxième motif (27) est gravé lors de l'étape b) afin de former au moins un évidement (28) communiquant avec ladite au moins une cavité offrant à ladite couche supérieure un deuxième niveau.

3. Procédé (3) selon la revendication 1, **caractérisé en ce qu'**une pièce (27') est montée après l'étape d) afin de former au moins un évidement (28') communiquant avec ladite au moins une cavité offrant audit moule un deuxième niveau.

4. Procédé (3) selon l'une des revendications précédentes, **caractérisé en ce qu'**il comporte l'étape finale suivante :
e) former (8, 18) une tige (29, 29') par photolithographie dans ladite au moins une cavité afin de former un trou (42, 42') dans la future pièce (41, 41') réalisée dans ledit moule.

5. Procédé (3) selon l'une des revendications précédentes, **caractérisé en ce qu'**il comporte, à la suite des étapes précédentes, les étapes suivantes :
a')déposer un matériau électriquement conducteur dans le fond de ladite au moins une cavité ;
b') graver (11, 12, 14, 2, 4) un motif (26, 26', 27) dans la couche inférieure (23, 23') jusqu'au dépôt (33) dudit matériau conducteur afin de former au moins une cavité (35) dudit moule ;
c') recouvrir (6, 16) l'ensemble d'un deuxième revêtement (38) électriquement isolant.

6. Procédé (3) selon la revendication 5, **caractérisé en ce qu'**il comporte, à la suite de l'étape c'), l'étape suivante :
d')graver (8, 18) de manière directionnelle ledit deuxième revêtement afin de limiter sa présence uniquement au niveau de chaque paroi (39) verticale formée dans ladite couche inférieure.

7. Procédé (3) selon la revendication 6, **caractérisé en ce qu'**un deuxième motif est gravé lors de l'étape b') afin de former au moins un évidement communiquant avec ladite au moins une cavité offrant à ladite couche inférieure un deuxième niveau.

8. Procédé (3) selon la revendication 6, **caractérisé en ce qu'**une pièce est montée après l'étape d') afin de former au moins un évidement communiquant avec ladite au moins une cavité offrant audit moule un deuxième niveau.

9. Procédé (3) selon l'une des revendications 5 à 8, **caractérisé en ce qu'**il comporte l'étape finale suivante :
e')former une tige (37) par photolithographie dans ladite au moins une cavité de la couche inférieure (23, 23') afin de former un trou (42") dans la future pièce (41 ") réalisée dans ledit moule.

10. Procédé (3) selon l'une des revendications précédentes, **caractérisé en ce que** plusieurs moules (39, 39', 39") sont fabriqués sur le même substrat (9, 9', 9").

11. Procédé (3) selon l'une des revendications précédentes, **caractérisé en ce que** l'étape c) est obtenue par oxydation de la partie supérieure dudit substrat.

12. Procédé (3) selon la revendication précédente, **caractérisé en ce que** le revêtement (30, 30') électriquement isolant est formé par du dioxyde de silicium.

13. Procédé de fabrication (1) par galvanoplastie d'une pièce de micromécanique (41, 41', 41"), **caractérisé en ce qu'**il comprend les étapes suivantes :
i) fabriquer un moule (39, 39', 39") selon le procédé (3) conforme à l'une des revendications précédentes ;
j) réaliser (5) une électrodéposition en connectant l'électrode à la couche conductrice inférieure (23, 23') du substrat (9, 9', 9") afin de former ladite pièce dans ledit moule ;
k) libérer la pièce (41, 41', 41") dudit moule.

14. Moule (39, 39', 39") destiné à fabriquer une pièce de micromécanique (41, 41', 41") par galvanoplastie, **caractérisé en ce qu'**il comporte un substrat (9, 9', 9") comportant une couche supérieure (21, 21') et une couche inférieure (23, 23') en silicium cristallin dopé électriquement conductrices et solidarisées entre elles par une couche intermédiaire (22, 22') électriquement isolante, la couche supérieure (21, 21') comportant au moins une cavité (25, 25') découvrant une partie de la couche inférieure (23, 23') dudit substrat et comportant des parois (31, 31') en dioxyde de silicium électriquement isolantes permettant de faire croître un dépôt électrolytique dans ladite au moins une cavité.

15. Moule (39, 39', 39") selon la revendication 14, **caractérisé en ce que** la couche supérieure (21, 21') comporte en outre au moins un évidement (28, 28') situé communiquant avec ladite au moins une cavité et comportant des parois (32, 32') électriquement isolantes permettant de continuer le dépôt électrolytique dans ledit au moins un évidement après avoir rempli ladite au moins une cavité.

16. Moule (39") selon la revendication 14 ou 15, **caractérisé en ce que** la couche inférieure (23, 23') comporte au moins une cavité (35) découvrant une partie de couche (33) électriquement conductrice dudit substrat et comportant des parois (40) en dioxyde de silicium électriquement isolantes permettant de faire croître un dépôt électrolytique dans ladite au moins une cavité de la couche inférieure (23, 23').

17. Moule selon la revendication 16, **caractérisé en ce que** la couche inférieure (23, 23') comporte en outre au moins un évidement situé communiquant avec ladite au moins une cavité de la couche inférieure (23, 23') et comportant des parois électriquement isolantes permettant de continuer le dépôt électrolytique dans ledit au moins un évidement après avoir rempli ladite au moins une cavité de la couche inférieure (23, 23').

## Patentansprüche

1. Verfahren (3) zum Herstellen einer Form (39, 39', 39"), das die folgenden Schritte umfasst:
a) Vorsehen (10) eines Substrats (9, 9'), das eine obere Schicht (21, 21') und eine untere Schicht (23, 23') aus kristallinem Silicium, das mit einem elektrischen Leiter dotiert ist, die durch eine elektrisch isolierende Zwischenschicht (22, 22') miteinander verbunden sind, enthält;
b) Ätzen (11, 12, 14, 2, 4) wenigstens eines Musters (26, 26', 27) in der oberen Schicht (21, 21') bis zu der Zwischenschicht (22, 22'), um wenigstens einen Hohlraum (25, 25') der Form zu bilden;
c) Abdecken (6, 16) des oberen Teils des Substrats mit einer elektrisch isolierenden Beschichtung (30, 30');
d) Ätzen (8, 18) auf gerichtete Weise der Beschichtung und der Zwischenschicht, um ihr Vorhandensein ausschließlich auf die Höhe jeder vertikalen Wand (31, 31', 33), die in der oberen Schicht gebildet ist, einzuschränken.

2. Verfahren (3) nach Anspruch 1, **dadurch gekennzeichnet, dass** im Schritt b) ein zweites Muster (27) geätzt wird, um wenigstens eine Aussparung (28) zu bilden, die mit dem wenigstens einen Hohlraum kommuniziert und für die obere Schicht eine zweite Höhe bietet.

3. Verfahren (3) nach Anspruch 1, **dadurch gekennzeichnet, dass** nach dem Schritt d) ein Teil (27') montiert wird, um wenigstens eine Aussparung (28') zu bilden, die mit dem wenigstens einen Hohlraum kommuniziert und für die Form eine zweite Höhe bietet.

4. Verfahren (3) nach einem der vorhergehenden Ansprüche, **dadurch gekennzeichnet, dass** es den folgenden letzten Schritt umfasst:
e) Bilden (8, 18) eines Stifts (29, 29') durch Photolithographie in dem wenigstens einen Hohlraum, um in dem künftigen Teil (41, 41'), das in der Form verwirklicht wird, ein Loch (42, 42') zu bilden.

5. Verfahren (3) nach einem der vorhergehenden Ansprüche, **dadurch gekennzeichnet, dass** es nach den vorhergehenden Schritten die folgenden Schritte umfasst:
a') Ablagern eines elektrisch leitenden Materials auf dem Boden des wenigstens einen Hohlraums;
b') Ätzen (11, 12, 14, 2, 4) eines Musters (26, 26', 27) in der unteren Schicht (23, 23') bis zu der Ablagerung (33) des leitenden Materials, um wenigstens einen Hohlraum (35) der Form zu bilden;
c') Abdecken (6, 16) der Gesamtheit mit einer zweiten elektrisch isolierenden Abdeckung (38).

6. Verfahren (3) nach Anspruch 5, **dadurch gekennzeichnet, dass** es nach dem Schritt c') den folgenden Schritt umfasst:
d') Ätzen (8, 18) auf gerichtete Weise der zweiten Beschichtung, um ihr Vorhandensein ausschließlich auf Höhe jeder vertikalen Wand (39), die in der unteren Schicht gebildet ist, einzuschränken.

7. Verfahren (3) nach Anspruch 6, **dadurch gekennzeichnet, dass** im Schritt b') ein zweites Muster geätzt wird, um wenigstens eine Aussparung zu bilden, die mit dem wenigstens einen Hohlraum kommuniziert und für die untere Schicht eine zweite Höhe bietet.

8. Verfahren (3) nach Anspruch 6, **dadurch gekennzeichnet, dass** nach dem Schritt d') ein Teil montiert wird, um wenigstens eine Aussparung zu bilden, die mit dem wenigstens einen Hohlraum kommuniziert und für die Form eine zweite Höhe bietet.

9. Verfahren (3) nach einem der Ansprüche 5 bis 8, **dadurch gekennzeichnet, dass** es den folgenden letzten Schritt umfasst:
e') Bilden eines Stifts (37) durch Photolithographie in dem wenigstens einen Hohlraum der unteren Schicht (23, 23'), um in dem künftigen Teil (41"), das in der Form verwirklicht wird, ein Loch (42") zu bilden.

10. Verfahren (3) nach einem der vorhergehenden Ansprüche, **dadurch gekennzeichnet, dass** auf demselben Substrat (9, 9', 9") mehrere Formen (39, 39', 39") hergestellt werden.

11. Verfahren (3) nach einem der vorhergehenden Ansprüche, **dadurch gekennzeichnet, dass** der Schritt c) durch Oxidation des oberen Teils des Substrats erhalten wird.

12. Verfahren (3) nach dem vorhergehenden Anspruch, **dadurch gekennzeichnet, dass** die elektrisch isolierende Beschichtung (30, 30') durch Siliciumdioxid gebildet wird.

13. Herstellungsverfahren (1) durch Galvanoplastie eines mikromechanischen Teils (41, 41', 41 "), **dadurch gekennzeichnet, dass** es die folgenden Schritte umfasst:
i) Herstellen einer Form (39, 39', 39") gemäß dem Verfahren (3) nach einem der vorhergehenden Ansprüche;
j) Verwirklichen (5) einer Elektroabscheidung durch Verbinden der Elektrode mit der unteren leitenden Schicht (23, 23') des Substrats (9, 9', 9"), um das Teil in der Form zu bilden;
k) Freigeben des Teils (41, 41', 41 ") von der Form.

14. Form (39, 39', 39"), die für die Herstellung eines mikromechanischen Teils (41, 41', 41") durch Galvanoplastie bestimmt ist, **dadurch gekennzeichnet, dass** sie ein Substrat (9, 9', 9") umfasst, das eine obere Schicht (21, 21') und eine untere Schicht (23, 23') aus kristallinem Silicium, das mit einem elektrischen Leiter dotiert ist, die durch eine elektrisch isolierende Zwischenschicht (22, 22') miteinander verbunden sind, enthält, wobei die obere Schicht (21, 21') wenigstens einen Hohlraum (25, 25') umfasst, der einen Teil der unteren Schicht (23, 23') des Substrats abdeckt und elektrisch isolierende Wände (31, 31') aus Siliciumdioxid aufweist, die ermöglichen, eine elektrolytische Ablagerung in dem wenigstens einen Hohlraum aufwachsen zu lassen.

15. Form (39, 39', 39") nach Anspruch 14, **dadurch gekennzeichnet, dass** die obere Schicht (21, 21') außerdem wenigstens eine Aussparung (28, 28') aufweist, die so angeordnet ist, dass sie mit dem wenigstens einen Hohlraum kommuniziert, und elektrisch isolierende Wände (32, 32') aufweist, die ermöglichen, die elektrolytische Ablagerung in der wenigstens einen Aussparung fortzusetzen, nachdem der wenigstens eine Hohlraum gefüllt worden ist.

16. Form (39") nach Anspruch 14 oder 15, **dadurch gekennzeichnet, dass** die untere Schicht (23, 23') wenigstens einen Hohlraum (35) umfasst, der einen Teil der elektrisch leitenden Schicht (33) des Substrats abdeckt und elektrisch isolierende Wände (40) aus Siliciumdioxid aufweist, die ermöglichen, eine elektrolytische Ablagerung in dem wenigstens einen Hohlraum der unteren Schicht (23, 23') aufwachsen zu lassen.

17. Form nach Anspruch 16, **dadurch gekennzeichnet, dass** die untere Schicht (23, 23') außerdem wenigstens eine Aussparung umfasst, die so angeordnet ist, dass sie mit dem wenigstens einen Hohlraum der unteren Schicht (23, 23') kommuniziert, und elektrisch isolierende Wände aufweist, die ermöglichen, die elektrolytische Ablagerung in der wenigstens einen Aussparung fortzusetzen, nachdem der wenigstens eine Hohlraum der unteren Schicht (23, 23') gefüllt worden ist.

## Claims

1. Method (3) of fabricating a mould (39, 39', 39") including the following steps:
a) providing (10) a substrate (9, 9') that has a top layer (21, 21') and a bottom layer (23, 23') made of electrically conductive doped crystalline silicon secured to each other by an electrically insulating, intermediate layer (22, 22');
b) etching (11, 12, 14, 2, 4) at least one pattern (26, 26', 27) in the top layer (21, 21') as far as the intermediate layer (22, 22') so as to form at least one cavity (25, 25') in said mould;
c) coating (6, 16) the top part of said substrate with an electrically insulating coating (30, 30');
d) directionally etching (8, 18) said coating and said intermediate layer to limit the presence thereof exclusively at each vertical wall (31, 31', 33) formed in said top layer.

2. Method (3) according to claim 1, **characterized in that** a second pattern (27) is etched in step b) to form at least one recess (28) that communicates with said at least one cavity and provides said top layer with a second level.

3. Method (3) according to claim 1, **characterized in that** a part (27') is mounted after step d) to form at least one recess (28') that communicates with said at least one cavity and provides said mould with a second level.

4. Method (3) according to any of the preceding claims, **characterized in that** it includes the following final step:
e) forming (8, 18) a rod (29, 29') by photolithography in said at least one cavity to form a hole (42, 42') in the future part (41, 41') made in said mould.

5. Method (3) according to any of the preceding claims, **characterized in that**, after the preceding steps, it includes the following steps:
a') depositing an electrically conductive material in the bottom of said at least one cavity;
b') etching (11, 12, 14, 2, 4) a pattern (26, 26', 27) in the bottom layer (23, 23') as far as the deposition (33) of said conductive material to form at least one cavity (35) in said mould;
c') coating (6, 16) the assembly with a second, electrically insulating coating (38).

6. Method (3) according to claim 5, **characterized in that**, after step c'), it includes the following step:
d') directionally etching (8, 18) said second coating to limit the presence thereof, exclusively at each vertical wall (39) formed in said bottom layer.

7. Method (3) according to claim 6, **characterized in that** a second pattern is etched in step b') to form at least one recess that communicates with said at least one cavity and provides said bottom layer with a second level.

8. Method (3) according to claim 6, **characterized in that** a part is mounted after step d') to form at least one recess that communicates with said at least one cavity and provides said mould with a second level.

9. Method (3) according to any of claims 5 to 8, **characterized in that** it includes the following final step:
e') forming a rod (37) in said at least one cavity of the bottom layer (23, 23') by photolithography to form a hole (42") in the future part (41") made in said mould.

10. Method (3) according to any of the preceding claims, **characterized in that in that** several moulds (39, 39', 39") are fabricated on the same substrate (9, 9', 9").

11. Method (3) according to any of the preceding claims, **characterized in that** step c) is obtained by oxidising the top part of said substrate.

12. Method (3) according to the preceding claim, **characterized in that** the electrically insulating coating (30, 30') is formed of silicon dioxide.

13. Method (1) of fabricating a micromechanical part (41, 41', 41") by galvanoplasty, **characterized in that** it includes the following steps:
i) fabricating a mould (39, 39', 39") in accordance with the method (3) of any of the preceding claims;
j) performing (5) an electrodeposition by connecting the electrode to the conductive bottom layer (23, 23') of the substrate (9, 9', 9") to form said part in said mould;
k) releasing the part (41, 41', 41 ") from said mould.

14. Mould (39, 39', 39") for fabricating a micromechanical part (41, 41', 41 ") by galvanoplasty, **characterized in that** it includes a substrate (9, 9', 9") with a top layer (21, 21') and a bottom layer (23, 23'), which are made of doped crystalline silicon, electrically conductive and secured to each other by an electrically insulating intermediate layer (22, 22'), wherein the top layer (21, 21') includes at least one cavity (25, 25') that reveals part of the bottom layer (23, 23') of said substrate and includes electrically insulating silicon dioxide walls (31, 31'), enabling an electrolytic deposition to be grown in said at least one cavity.

15. Mould (39, 39', 39") according to claim 14, **characterized in that** the top layer (21, 21') also has at least one recess (28, 28') that communicates with said at least one cavity and has electrically insulating walls (32, 32') for continuing the electrolytic deposition in said at least one recess after said at least one cavity has been filled.

16. Mould (39") according to claim 14 or 15, **characterized in that** the bottom layer (23, 23') has at least one cavity (35) that reveals part of the electrically insulating layer (33) of said substrate and has electrically insulating silicon dioxide walls (40) enabling an electrolytic deposition to be grown in said at least one cavity of the bottom layer (23, 23').

17. Mould according to claim 16, **characterized in that** the bottom layer (23, 23') also includes at least one recess that communicates with said at least one cavity of the bottom layer (23, 23') and has electrically insulating walls for continuing the electrolytic deposition in said at least one recess after said at least one cavity in the bottom layer (23, 23') has been filled.
